(19) Europäisches Patentamt
European Patent Office
Office européen des brevets

(11) **EP 2 095 078 B1**

(12) **EUROPÄISCHE PATENTSCHRIFT**

(45) Veröffentlichungstag und Bekanntmachung des Hinweises auf die Patenterteilung:
**19.06.2013 Patentblatt 2013/25**

(21) Anmeldenummer: **07819623.5**

(22) Anmeldetag: **06.11.2007**

(51) Int Cl.:
*G01D 5/241* (2006.01)          *G01D 5/249* (2006.01)
*H05K 13/04* (2006.01)

(86) Internationale Anmeldenummer:
**PCT/EP2007/009604**

(87) Internationale Veröffentlichungsnummer:
**WO 2008/064760 (05.06.2008 Gazette 2008/23)**

(54) **KAPAZITIVER WINKELKODIERER UND FEEDEREINSCHUB FÜR BESTÜCKUNGSMASCHINEN VON LEITERPLATTEN**

CAPACITIVE ANGLE ENCODER AND WITHDRAWABLE FEEDER FOR CIRCUIT BOARD COMPONENT INSERTION MACHINES

DISPOSITIF DE CODAGE ANGULAIRE CAPACITIF ET CHARGEUR ENFICHABLE POUR MACHINES D'ÉQUIPEMENT DE CARTES DE CIRCUIT IMPRIMÉ

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **30.11.2006 DE 102006056609**

(43) Veröffentlichungstag der Anmeldung:
**02.09.2009 Patentblatt 2009/36**

(73) Patentinhaber: **Maxon Motor AG**
**6072 Sachseln (CH)**

(72) Erfinder: **BUSSE-GRAWITZ, Max Erick**
**6055 Alpnach Dorf OW (CH)**

(74) Vertreter: **Grünecker, Kinkeldey,**
**Stockmair & Schwanhäusser**
**Leopoldstrasse 4**
**80802 München (DE)**

(56) Entgegenhaltungen:
**WO-A-02/080643      US-A1- 2005 092 108**
**US-B1- 6 170 162**

• **WOLFFENBUTTEL R F ET AL: "AN INTEGRABLE CAPACITIVE ANGULAR DISPLACEMENT SENSOR WITH IMPROVED LINEARITY" SENSORS AND ACTUATORS A, ELSEVIER SEQUOIA S.A., LAUSANNE, CH, Bd. A27, Nr. 1 - 03, 1. Mai 1991 (1991-05-01), Seiten 835-843, XP000216788 ISSN: 0924-4247**

**Beschreibung**

Die vorliegende Erfindung bezieht sich auf einen kapazitiven Winkelkodierer zum Erfassen einer Drehstellung eines rotatorisch beweglichen Objekts relativ zu einem stationären Objekt. Insbesondere betrifft die vorliegende Erfindung einen derartigen kapazitiven Winkelkodierer, der in einem Feedereinschub für Bestückungsmaschinen von Leiterplatten eingesetzt werden kann. Die Erfindung betrifft außerdem einen Feedereinschub für Bestückungsmaschinen von Leiterplatten, der mit einem erfindungsgemäßen Winkelkodierer ausgestattet ist.

Bestückungsmaschinen werden eingesetzt, um elektronische Bauteile auf einer Leiterplatte zu positionieren. Die elektronischen Bauteile sind auf einem Transportband aus Karton oder Kunststoff angeordnet und mit einem weiteren Band abgedeckt. Das Transportband wird zu einer Rolle aufgewickelt und in einen Feeder eingesetzt. Das Transportband weist an mindestens einer Seite Löcher auf, in die ein über einen Antriebsmotor angetriebenes Stachelrad eingreift und das Transportband somit bewegt. Gleichzeitig wird die Abdeckfolie abgezogen, so dass die elektronischen Bauteile freiliegen. Die elektronischen Bauteile werden durch das Stachelrad genau an einer Übergabestelle positioniert, mit einer Vakuumpipette entnommen und auf der Leiterplatte platziert.

Da heutige elektronische Bauteile immer kleiner werden und ihre Anzahl auf einer Leiterplatte kontinuierlich zunimmt, müssen moderne Bestückungsmaschinen Platz für eine möglichst große Anzahl von Feedereinschüben mit Transportbändern mit den elektronischen Bauteilen bieten. Aus Platzgründen müssen die einzelnen Feedereinschübe möglichst schmal sein.

Gleichzeitig muss die Position der Bauteile über eine Überwachung der Position des Stachelrads immer exakter detektiert und gegebenenfalls korrigiert werden. Ein Beispiel für einen bekannten Feedereinschub für Bestückungsmaschinen von Leiterplatten ist in der DE 10 2006 024 733.7 beschrieben.

Zur Überwachung einer Drehstellung eines rotatorisch beweglichen Objekts mit Bezug auf ein stationäres Objekt sind kapazitive Winkelgeber bekannt, welche die Kapazitätsänderung zwischen beweglichen auf einem Rotor angeordneten Elektroden und ortsfesten auf einem Stator angeordneten Elektroden auswerten. Eine Übersicht über bekannte kapazitive Winkelkodierer ist beispielsweise der internationalen veröffentlichten Patentanmeldung WO 00/63653 A2 zu entnehmen. Allerdings haben die in dieser Druckschrift vorgeschlagenen Lösungen sämtlich den Nachteil, dass sie nicht die für moderne Bestückungsmaschinen erforderliche Genauigkeit liefern und darüber hinaus einer elektrischen Abschirmung zum Schutz vor elektromagnetischen Einstreuungen bedürfen, wodurch die Baugröße weiter unzulässig erhöht wird.

Die Schrift "AN INTEGRABLE CAPACITIVE ANGULAR DISPLACEMENT SENSOR WITH IMPROVED LINEARITY", WOLFENBUTTEL R F ET AL, SENSORS AND ACTUATORS, ELSEVIER SEQUOIA S.A., LAUSANNE, CH, Bd. A27, Nr. 1-03, 1. Mai 1991, Seiten 835-843) bezieht sich auf einen hochauflösenden kapazitiven Winkelgeber, der einen hochauflösenden Inkrementalencoder mit einem niedriger auflösenden absoluten Encoder kombiniert. Die kombinierte Auswertung dieser beiden Strukturen führt zu einem hochauflösenden absoluten Winkelencoder. Auf dem Stator sind vier Treiberelektroden, die mit vier jeweils um 90° gegeneinander phasenverschobenen sinusförmigen Spannungen gespeist werden, angeordnet. Durch die kapazitive Kopplung mit dem Rotor entsteht auf diesem eine sinusförnige Spannung, die kapazitiv zu der Pick-UpElektrode auf dem Stator rückgekoppelt werden kann und dort gemessen wird. Die Phase der Spannung an der Pick-Up-Elektrode hängt von dem Rotationswinkel $\Phi$ ab und durch eine entsprechende Auswerteschaltung kann daraus der Drehwinkel berechnet werden. Um das Ausgangsignal zu linearisieren wird vorgeschlagen, sichelförmige Elektrodenstrukturen sowohl für die Absolutwertmessung wie auch für die Inkrementalwertmessung zu verwenden.

Das Dokument US 2005/092108 A1 offenbart einen kapazitiven Encoder mit Sende- und Empfangselektroden, die auf unterschiedlichen Ebenen angeordnet sind, und eine Abschirmelektrode, die eine sinusförmige Struktur aufweist, die umlaufend an ihrem Rand ausgebildet ist.

Das Dokument US 6,170,162 B1 offenbart einen Winkelgeber, bei dem sowohl eine absolute wie auch eine relative Messung von Drehwinkelpositionen durchgeführt wird. Dabei ist eine sogenannte Emitterscheibe vorgesehen, welche die Sendeelektroden beinhaltet und eine Detektorplatte, auf der ein Detektorchip angeordnet ist. Die Detektorplatte ist so fixiert, dass sie nicht rotiert, während die Emitterscheibe der zu detektierenden Rotationsbewegung folgt.

Insbesondere im Zusammenhang mit derartigen miniaturisierten und hochgenauen Feedereinschüben besteht daher das Bedürfnis nach einem Positionsgebersystem, das einerseits eine möglichst hohe Positioniergenauigkeit des Feeders ermöglicht und zum anderen eine geringe Bauhöhe und möglichst hohe Robustheit gegenüber elektromagnetischen Störungen aufweist.

Diese Aufgabe wird durch einen kapazitiven Winkelkodierer mit den Merkmalen des Patentanspruchs 1 gelöst. Vorteilhafte Weiterbildungen der vorliegenden Erfindung sind Gegenstand der abhängigen Patentansprüche.

Dabei basiert die vorliegende Erfindung auf der Idee, einen kapazitiven Winkelkodierer so auszubilden, dass gleichzeitig eine Inkrementalmessung wie auch eine Absolutmessung der Position des beweglichen Objekts durchgeführt wird und Sende- und Empfangselektroden zusammen auf ein und demselben stationären Substrat angeordnet sind, wobei auf dem Rotor leitfähige Muster angeordnet sind, so genannte Koppelelektroden, die durch das ausgesendete elektromagnetische Feld beeinflusst werden und durch ihre Bewegung das von den Empfangselektroden gemessene Feld verändern.

Damit ist das Ausgangssignal der Empfangselektrode eine Funktion der sich verändernden Kapazität zwischen Rotor und Stator. Erfindungsgemäß sind die Sende- und Empfangselektroden für das inkrementale Gebersystem und das absolute Gebersystem koplanar zueinander angeordnet. Auf diese Weise können alle stationären Elektroden in einem Arbeitsgang hergestellt werden und haben einen minimalen Platzbedarf. Eine Signalverarbeitungsschaltung ist vorgesehen, um die von den jeweiligen Empfangselektroden gelieferten Signale auszuwerten und einen Messwert für die Position des sich bewegenden Objekts, beispielsweise des Stachelrads eines Feedereinschubs, zu liefern. Selbstverständlich kann aber die erfindungsgemäße kapazitive Winkelkodiereranord-nung auch zur Überwachung beliebiger anderer Drehstellungen verwendet werden, bei denen hohe Genauigkeit und geringe Baugrößen gefordert sind.

Gemäß einer vorteilhaften Ausführungsform ist die mindestens eine Sendeelektrode, die zu dem Inkrementalgebersystem gehört, durch vier gleichartige Gruppen von Sendeelektroden gebildet, die so verschaltet sind, dass jede Gruppe mit einem zu den übrigen Gruppen im Wesentlichen orthogonalen Sendesignal gespeist wird. Eine solche differenzielle Anregung führt zu einer Differenzbildung der Signale und ist vor allem bei schnellen Vorgängen von Vorteil, weil keine Probleme mit dem Gleichtaktunterdrückungsverhältnis (common mode rejection ratio, CMRR) auftreten. Insbesondere ein schneller und empfindlicher Winkelkodierer benötigt hohe Frequenzen. Das Gleichtaktunterdrückungsverhältnis nimmt aber mit 20 dB/Dec ab und ist daher bei 20 mHz unbrauchbar. Dagegen existieren gute symmetrische Verstärker auch für sehr hohe Frequenzen. Erfindungsgemäß werden für die Ansteuerung der Sendeelektroden digitale Treiber eingesetzt, da hier ein besonders kostengünstiger Aufbau der Gesamtschaltung erreicht werden kann.

Sieht man weiterhin eine getrennte Auswertung der Quadraturkanäle, insbesondere durch Vorsehen von zwei Gruppen von Empfängerelektroden im Inkrementalpfad vor, so kann eine erhöhte Signalintegrität erreicht werden, d. h. es tritt kein Rauschen des jeweils anderen Kanals in einem der Kanäle auf.

Obwohl die interdigitale Anordnung der Empfangselektroden und der Sendeelektroden gesteigerte Anforderungen an die Strukturierung des Statorsubstrats mit sich bringt, insbesondere da eine hohe Anzahl von Durchkontaktierungen (Vias) und sehr feine Strukturen verlangt werden, hat diese Anordnung aber den signifikanten Vorteil, dass die Empfindlichkeit deutlich gesteigert werden kann.

Erfindungsgemäß wird die Inkrementalkoppelelektrode durch eine sinusförmige Struktur gebildet, die umlaufenden an dem Rotor ausgebildet ist, so dass ein sinusförmiges Ausgangssignal entsteht.

Erfindungsgemäß ist für die Auswertung des Inkrementalsignals und des Absolutwertsignals jeweils eine separate Signalverarbeitungsschaltung vorgesehen.

Verwendet man eine Phaseshift-Keying-Heterodyn-Architektur anstatt der üblicherweise verwendeten synchronen Mischung auf DC, so vermeidet man Probleme mit 1/f Rauschen, 50 Hz-Einstreuungen und dergleichen. Weiterhin kann eine volldigitale Demodulation durchgeführt werden, was die Störempfindlichkeit und Schaltungskomplexität deutlich verringert. Analog/Digital-Wandler werden bei der erfindungsgemäßen Signalverarbeitung nicht mehr benötigt.

Die erfindungsgemäße Anordnung ermöglicht außerdem die Verwendung eines Pseudo-Random-Cyclic (PRC)-Codes für den ausgegebenen Absolutwert. Hierfür müssen die Empfangselektroden jeweils n oder zweimal n einzelne Empfangselektroden (die auch als "Pickups" bezeichnet werden) umfassen, damit stets ein gültiger PRC-Wert abgelesen werden kann. Sieht man außerdem noch einen oder mehrere redundante Pickups vor, kann auch ein fehlerkorrigierender PRC-Code implementiert werden. Die Summenbildung findet direkt auf der Empfangselektrode statt und man erhält den Wert für n aus nachfolgender Berechnungsvorschrift:

$$n = \text{Aufrunden [log 2 (Anzahl Perioden der Inkrementalspur)]},$$

also z. B. n = 5 bei 72 Quad-Counts (=18 Perioden) oder n = 4 bei 64 Quad-Counts (= 16 Perioden).

Neben den reduzierten geometrischen Abmessungen bietet die erfindungsgemäße Konfiguration und Signalverarbeitung vor allem den Vorteil, dass die Winkelerfassung als offenes System und ohne geschlossene Abschirmung ausgebildet werden kann. Dadurch können einerseits die Montagekosten gering gehalten werden und andererseits kann wertvoller Bauraum eingespart werden.

Der erfindungsgemäße Winkelkodierer wird anhand der nachfolgenden Zeichnungen näher erläutert, wobei korrespondierende Komponenten und Elemente mit denselben Bezugszeichen versehen sind. Es zeigen:

**Fig. 1**     eine perspektivische Darstellung eines Stachelrads mit einer erfindungsgemäßen Koppelelektrodenstruktur;

**Fig. 2**     eine Draufsicht auf die zugehörige Elektrodenstruktur des Stators;

**Fig. 3**     ein Layout der rückseitigen Elektrodenverdrahtung der Anordnung aus Fig. 2;

**Fig. 4**     ein Layout der Koppelelektrodenstruktur aus Fig. 1;

**Fig. 5**     eine schematische Darstellung eines Stachelrads vor der Montage der Koppelelektroden;

**Fig. 6**     ein vereinfachtes Schaltbild einer kapazitiven Auswerteschaltung;

**Fig. 7**     ein vereinfachtes Schaltbild der in der erfindungsgemäßen Anordnung verwendeten Auswerteschaltung;

**Fig. 8**     ein vereinfachtes Schaltbild der digitalen Phasendetektion gemäß der vorliegenden Erfindung;

**Fig. 9**     eine beispielhafte Mischerstruktur gemäß der vorliegenden Erfindung;

**Fig. 10**    ein Prinzipschaltbild eines zweistufigen limitierenden Verstärkers, der zusammen mit der Anordnung aus Fig. 9 einsetzbar ist;

**Fig. 11**    eine Seitenansicht eines Feedereinschubs.

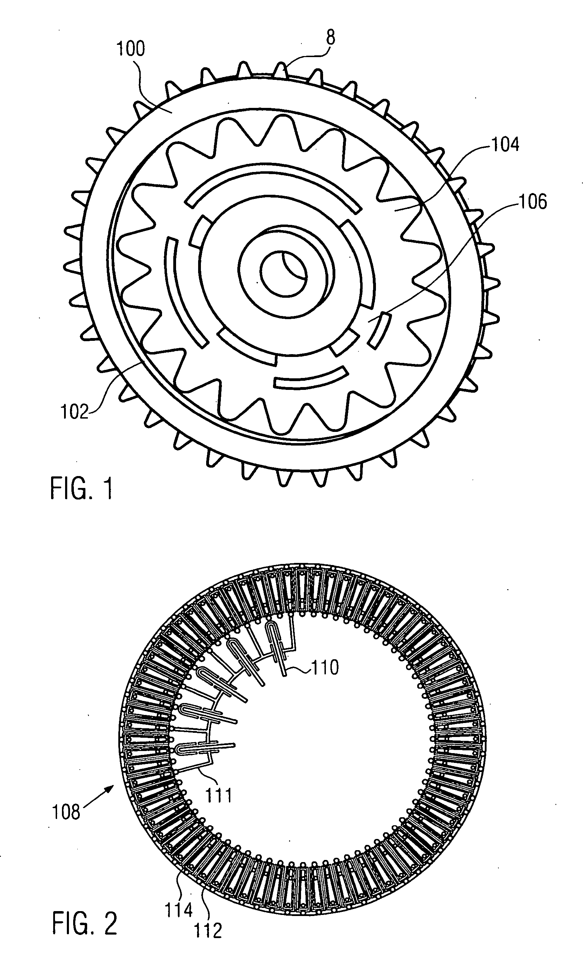

Fig. 1 zeigt in einer perspektivischen Darstellung ein Stachelrad 100 zur Positionierung eines Transportbands in einem Feedereinschub, das mit einer Koppelelektrode gemäß der vorliegenden Erfindung ausgestattet ist. Mit Hilfe der kapazitiven Auswertung der Position der Koppelelektrode oder auch Code-Scheibe 102 kann bei einem Feedereinschub gemäß der deutschen Patentanmeldung DE 10 2006 024 733.7 die geometrische Abweichung einzelner Zähne des Stachelrads 100 über einen Kalibriervorgang kompensiert werden. Dazu wird das Stachelrad 100 mit einem hochpräzisen Referenzsystem vermessen und die Korrekturwerte werden in einer Datentabelle abgelegt.

Erfindungsgemäß umfasst das Encoder-System nicht nur eine inkrementale Erfassung der Drehstellung des Stachelrads 100, sondern auch eine Erfassung der absoluten Winkelposition. Die Verwendung einer solchen absoluten Detektion ermöglicht eine direkte Zuordnung zu der Korrekturtabelle an jeder Übergabeposition, so dass kein Referenzpunkt angefahren werden muss und keine Bauteile verloren gehen. Erfindungsgemäß muss die Anzahl der zur Verfügung stehenden Absolutpositionen mindestens so groß wie die Anzahl der Übergabepositionen sein. Im vorliegenden Fall sind dies 72 Positionen, d. h. alle fünf Winkelgrade befindet sich eine Übergabeposition an dem Stachelrad 100. Das Messprinzip, das bei dem vorliegenden Winkelkodierer verwendet wird, ist ein kapazitives Verfahren, bei dem auf einem Stator (in Fig. 2 mit dem Bezugszeichen 108 bezeichnet) Sendeelektroden 111, 112 und Empfangselektroden 110, 114 angeordnet sind, die sich jeweils in unmittelbarer Nähe zueinander befinden. Das von der Sendeelektrode ausgesendete elektrostatische Feld wird durch Koppelelektroden der Code-Scheibe 102 und insbesondere durch deren geometrische Lage mit Bezug auf die Empfangselektroden des Stators 108 moduliert, so dass durch Auswertung des Signals an den Empfangselektroden des Stators 108 die Information über die Position des Stachelrads 100 gewonnen werden kann.

Erfindungsgemäß ist bei dem vorliegenden Winkelkodierer sowohl ein Inkrementalsystem, bestehend aus einer sinusförmigen Inkrementalspur 104 an der beweglichen Code-Scheibe 102 und einem am Umfang des Stators angeordneten Array von interdigitalen Sende- und Empfangselektroden, wie auch ein Absolutwertgebersystem vorgesehen, das als Koppelelektrode eine Absolutspur 106 an der Code-Scheibe 102 umfasst und Sendeelektroden 111 sowie Empfangselektroden 110, so genannte Pickups, an dem Stator 108.

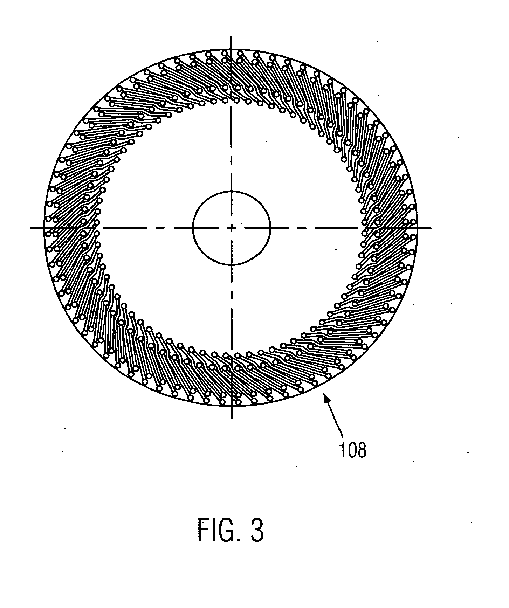

Wie in Fig. 3 gezeigt, werden die einzelnen Elektrodenstrukturen auf der Rückseite des Stators 108 elektrisch verschaltet und mit der (in den Figuren nicht dargestellten) Signalverarbeitung verbunden.

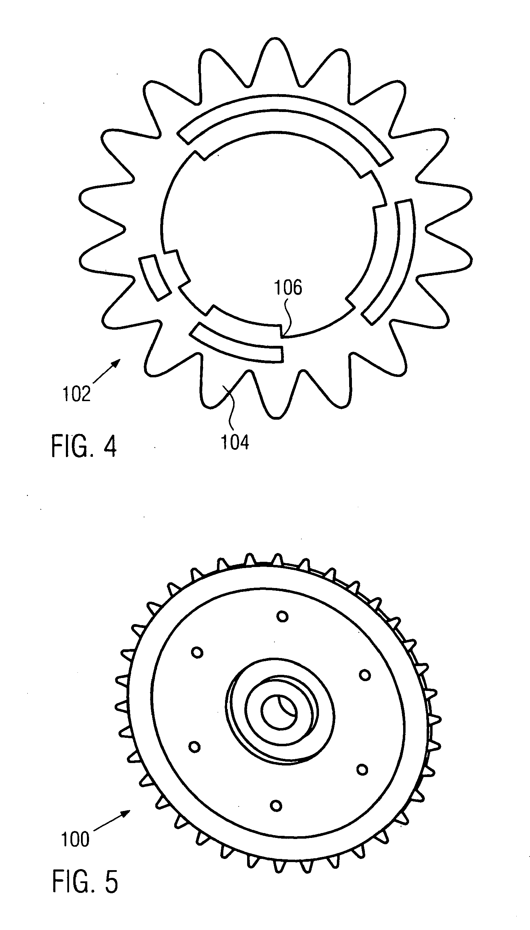

Die als Koppelelektrode fungierende Code-Scheibe 102 wird gelegentlich auch als Target oder Zielscheibe bezeichnet. Diese Code-Scheibe ist in Fig. 4 nochmals in der direkten Draufsicht gezeigt, während Fig. 5 eine perspektivische Darstellung des Stachelrads 100 ohne die Code-Scheibe ist.

Allgemein ist bekannt, dass eine geeignet strukturierte Zielscheibe eine positionsabhängige Kapazität auf einem so genannten Pickup, einer Empfängerelektrodenanordnung, erzeugt. Grundsätzlich besteht aber immer der Nachteil bei kapazitiven Aufnehmern, dass die Kapazität nicht nur abhängig ist von der zu messenden Zielgröße, also im vorliegenden Fall dem Drehwinkel $\varphi$, sondern auch von vielen anderen unerwünschten Variablen, wie dem Abstand zum Target, der Temperatur und anderen Störgrößen.

Um diese Störeinflüsse zu eliminieren, ist bekannt, die Messung vierfach auszuführen, so dass pro so genanntem "Quad-Count" eine Messung entsteht. Man spricht hierbei von 0°, 90°, 180° und 270° in elektrischen Graden. Durch eine solche orthogonale und differenzielle Anordnung erhält man eine eindeutige Winkelinformation unabhängig von Offset und Skalierung. Bei der in Fig. 2 gezeigten Statoranordnung sind für das Inkrementalgebersystem 4 x 18 Sende- und Empfangselektroden zusammengeschaltet, so dass sich vier Elektroden ergeben, die im Folgenden A+, B+, A- und B- genannt werden, wobei A = A+ + A- und B = B+ + B-. Ein Nulldurchgang beim A- oder B-Signal ergibt einen Quad-Count.

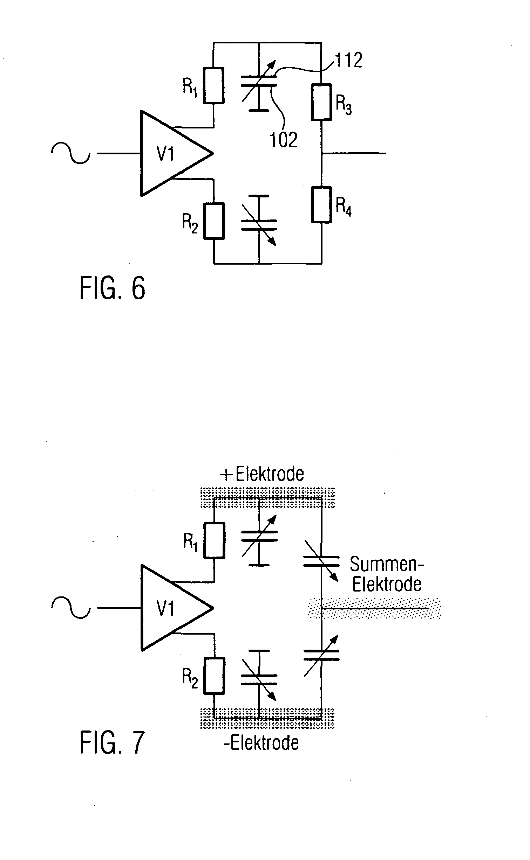

Wie bereits erwähnt, werden bei einem kapazitiven Encoder oder Winkelkodierer Änderungen der Kapazität gemessen, wobei die Anforderung besteht, dass die Messung unempfindlich sein sollte gegen Drift, Leakage, Temperatureinflüsse und dergleichen. Deshalb wird in bekannter Weise eine Differenzkapazität wie in Fig. 6 dargestellt bestimmt. Bei der in Fig. 6 dargestellten Anordnung entspräche die Masseelektrode der Code-Scheibe 102 und die Sendeelektrode 112 auf dem Stator wäre die Gegenelektrode.

Bei der in Fig. 6 gezeigten Anordnung treibt ein symmetrischer, im Gegentakt betriebener Verstärker über zwei identische Ausgangswiderstände R1, R2 die zu messenden Kapazitäten. Die Spannung bricht dabei abhängig von den Kapazitäten zusammen. Über die Ausgangswiderstände R3, R4 findet eine Summenbildung statt, die bei identischen Kapazitäten 0 ergibt.

Diese Architektur hat jedoch mehrere Nachteile: Die Genauigkeit der Messung hängt von der Symmetrie des Verstärkers V1 wie auch von der Austarierung der vier Widerstände R1 bis R4 ab. Die vier Widerstände R1 bis R4 dämpfen einerseits das Messsignal und fügen ihm andererseits Rauschen hinzu. Schließlich wäre zur Vermeidung der Nachteile der Widerstandsschaltung die Verwendung eines Treiberverstärkerpaars denkbar, was aber zu einer Verteuerung der Schaltung führen würde.

Deshalb verwendet der erfindungsgemäße Winkelkodierer die bereits mit Bezug auf die Fig. 1 und 2 angesprochene Anordnung mit Sende- und Empfangselektroden auf dem Stator und eine nur als Koppelelektrode fungierende Elektrode auf dem Rotor. Diese Messung der so genannten Transkapazität nützt die Eigenschaft der Zielscheibe 102, dass sie auch als Abschirmung wirkt. Das heißt, wenn statt einer Elektrode deren zwei auf dem Stator platziert werden, kann als so genannte Transkapazität die Kapazität zwischen diesen Elektroden gemessen werden. Dabei ist der Zusammenhang zwischen dem Abstand der Zielscheibe 102 und der messbaren Kapazität umgekehrt wie in dem in Fig. 6 gezeigten Fall: je näher die Zielscheibe, desto kleiner ist die messbare Transkapazität. Die Kapazität der Koppelelektrode 102 gegen Masse existiert immer noch und nimmt zu, wenn sich die Zielscheibe nähert.

Die Messung der Transkapazität ist, wenn sie unipolar ausgeführt wird, selbstverständlich mit denselben Nachteilen behaftet wie die Messung der Kapazität gegen Masse gemäß Fig. 6. Namentlich ist das Verhältnis von Offset- zu Nutzsignal unbefriedigend. Deshalb muss auch die Messung der Transkapazität differenziell ausgeführt werden. Ein Prinzipschaltbild der erfindungsgemäßen Schaltungsanordnung ist in Fig. 7 gezeigt.

Der differenzielle Verstärker V1 treibt wie in Fig. 6 zwei Elektroden, die sich 180° zueinander befinden (also z. B. A+- und A--Elektroden oder B+- und B--Elektroden). In räumlich unmittelbarer Nähe zu den beiden Sendeelektroden 112 befindet sich erfindungsgemäß je eine Empfangselektrode, die auch als Pickup bezeichnet wird und zu einer Summenelektrode zusammengeschaltet ist, die den Ausgang der Schaltung bildet.

Da die Kapazitäten gegen Masse und die Transkapazitäten jeweils gegensinnige Verläufe annehmen, sind bei der in Fig. 7 gezeigten Schaltung die Widerstände R1 und R2 am Ausgang des Verstärkers V1 vorteilhaft, da sich der Spannungsteilereffekt und der Effekt der Transkapazität ergänzen. Allerdings wird, wie oben erwähnt, die absolute Amplitude des Signals reduziert. Deshalb werden gemäß einer vorteilhaften Ausführungsform die Widerstände R1 und R2 mit 0 Ω bestückt, also nur vom Innenwiderstand der Treiber bestimmt.

Um die Empfindlichkeit der in Fig. 7 gezeigten Schaltung zu erhöhen, würde sich eine Beschaltung mit Spulen anstelle der Widerstände R1 und R2 eignen, so dass die Beschaltung mit der Elektrodenstruktur in Resonanz kommt. Da sich der oben erwähnte Spannungsteilereffekt in diesem Fall allerdings negativ auswirkt, ist es wichtig, die Spulen so zu dimensionieren, dass die Resonanzfrequenz leicht unterhalb der Anregungsfrequenz liegt.

Bei einem Widerstandswert von R1 = R2 = 0 Ω und den in den Fig. 1 und 2 gezeigten geometrischen Anordnungen der Elektroden sind die folgenden Eckdaten für die auftretenden Werte zu erwarten: Kapazität des Pickups gegen Masse ca. 40 pF, maximale Amplitude bei symmetrischer 3 V-Anregung 17 mV, zu messende differenzielle Transkapazität bei 1/80° Verschiebung vom Neutralpunkt: 1 fF

Derart niedrige Kapazitätsänderungen lassen sich nur durch eine hochempfindliche Elektronik detektieren. Erfindungsgemäß ist eine Signalverarbeitungsschaltung vorgesehen, welche die Polarität der differenziellen Transkapazität detektieren kann. Die Messung läuft im Wesentlichen in zwei Stufen ab:

- Erzeugung einer symmetrischen Spannung für ein Elektrodenpaar, d. h. A+ und A-oder B+ und B-.

- Detektion der Polarität der am Ausgangs-Pickup auftretenden Spannung, um festzustellen, ob die Spannung mit dem Eingangssignal mitläuft oder gegenläuft.

Eine preisgünstige Art, zwei gegenläufige Signale als Speisespannung zu erzeugen, ist die Verwendung von Digitallogik. Die Anforderungen dabei sind: gute Symmetrie, da ansonsten das Tastverhältnis der Encoder-Signale von 50 % abweicht; Treiberwiderstand klein gegenüber der Reaktanz der Pickups, ausreichend hohe Frequenz, damit die zu erwartenden Ströme gut messbar sind; keine Beeinflussung von A- und B-Signalen, d. h. die A- und B-Signale müssen orthogonal zueinander sein, da sich ansonsten eine abstandsabhängige Verdrehung des Encoder-Signals ergibt.

Insbesondere aus der letzten Forderung ergibt sich, dass der Systemtakt möglichst viermal höher ist als der Signaltakt. Erfindungsgemäß kann beispielsweise ein Takt von 60 MHz gewählt werden, der dann auf 15 MHz heruntergeteilt wird. Die A+ -, B+ -, A- - und B- -Signale sind jeweils um 90 zueinander verschoben.

Um die Polarität der auftretenden Pickup-Spannung zu detektieren, wird, wie dies allgemein zum Detektieren des Winkels zwischen zwei Signalen üblich ist, ein Mischer benötigt. Im allgemeinsten Sinn ist ein Mischer eine Nichtlinearität, durch die eine Summe der zwei Signale verarbeitet wird. Durch die Nichtlinearität ergibt sich ein Produktterm, der die gewünschte Information enthält. Dabei haben bekannte Mischer drei Anschlüsse: RF (radio frequency) bezeichnet das zu analysierende Signal. LO (local oscillator) bezeichnet die Differenz, mit der das Signal verglichen wird, der Local Oscillator steht meist in sehr hoher Amplitude zur Verfügung und treibt die Nichtlinearität, oft ein Schalter. Bei vielen Mischern lassen sich RF und LO ohne nachteilige Folgen vertauschen.

IF (intermediate frequency) ist der Ausgang, der die Differenzfrequenz aus RF und LO führt. Meist führt der Ausgang noch andere Frequenzen, wie Summen und andere Produktterme, die geeignet durch Filterung eliminiert werden müssen.

Die Nichtidealitäten eines solchen Mischers sind unter anderem unerwünschte Produktterme, die Kompression des IF-Signals, was irrelevant ist, falls nur eine reine Polaritätsdetektion erwünscht ist, der so genannte LO to RF-Leakage, wodurch ein Offset erzeugt wird. Dieser Leakage entsteht vor allem durch parasitäre Kapazitäten. Diese lassen sich wegen ihrer Temperaturabhängigkeit und Nichtlinearität schlecht kompensieren, und schließlich der LO to IF-Leakage, der eher harmlos ist, aber weggefiltert werden muss.

Ein Mischer (oder Mixer) mit einem sehr niedrigen LO to RF-Leakage (weniger als beispielsweise 40 dB) ist ausgesprochen teuer und deshalb wird erfindungsgemäß ein direktes Heruntermischen auf DC vermieden, weil beim resultierenden Ausgangssignal das Nutzsignal nicht vom Offset unterschieden werden kann. Andere Gründe, die gegen ein Heruntermischen auf DC sprechen, sind das 1/f Rauschen und alle im Audio-Frequenzbereich vorkommenden Störungen wie 50 Hz, Pulsweiten-Modulation des Motors, Schaltnetzteile und dergleichen.

Daher wird erfindungsgemäß auf eine Intermediate Frequency IF heruntergemischt, die sich gut genug von DC unterscheidet, also z. B. eine RF von 15 MHz, ein LO von 14 MHz und eine IF von 1 MHz und 29 MHz (letztere wird weggefiltert). Eine derartige Architektur bezeichnet man als Heterodyn-Architektur.

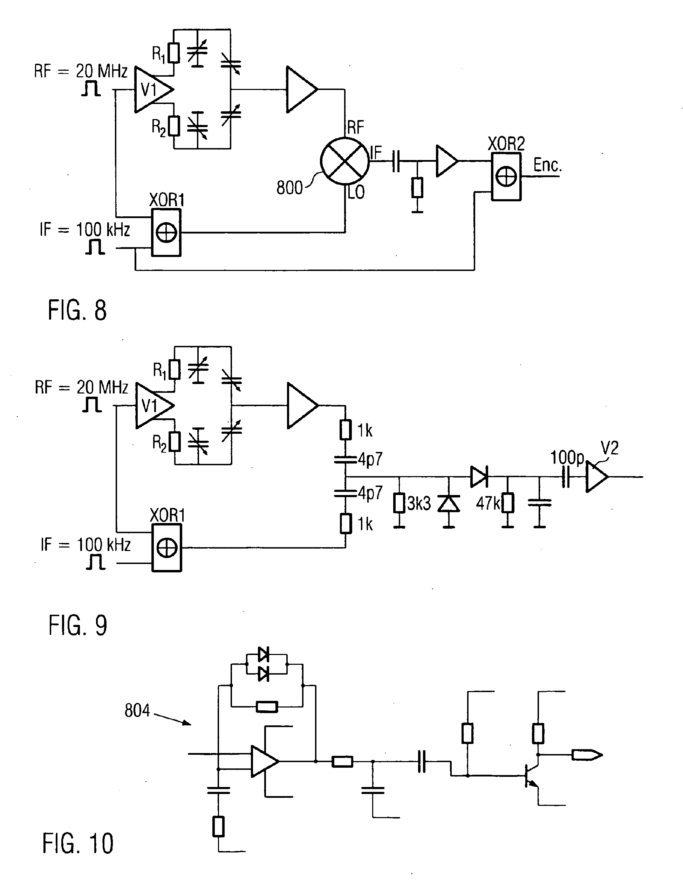

Erfindungsgemäß wird eine digitale Variante einer Heterodyn-Architektur realisiert, die in Fig. 8 dargestellt ist. Dabei basiert die erfindungsgemäße Schaltungsanordnung auf den folgenden Überlegungen:

Wenn die RF mit einem mitlaufenden LO analysiert wird, ergibt sich eine Spannung am Ausgang des Mischers, die ausgedrückt werden kann als U = f(RF) + g(LO), wobei der Term g (LO) so stark dominant ist (aufgrund des LO to RF Leakage), dass der Nutzsignal-term f von RF nicht sinnvoll auszuwerten ist. Wird die RF mit einem gegenläufigen LO analysiert, ergibt sich am Ausgang des Mixers die Spannung U = -f(RF) + g(LO). Werden die beiden oben genannten Schritte abwechslungsweise durchgeführt, ergibt sich eine Ausgangsspannung U = g(LO) +/- f(RF). Der Term g(LO) ist ein DC Offset, der mit einem Hochpass eliminiert werden kann. Es resultiert ein Term +/-f(RF), der entweder mit den oben genannten Messungen mitläuft oder entgegengesetzt verläuft. Dieser Term kann durch eine gute Verstärkung zu einem Digitalwert konvertiert werden. Die Auswertung ergibt sich dann mittels Exklusiv Oder (XOR)-Gliedern.

Bei der in Fig. 8 gezeigten Prinzipschaltung eines solchen kapazitiven Encoders mit digitaler Phasendetektion dient das erste Exklusiv Oder-Tor XOR1 dazu, die Polarität des RF-Signals periodisch umzuschalten. Das zweite Exklusiv Oder-Tor XOR2 testet, ob das Ausgangssignal mit oder gegen die IF verläuft. Am Ausgang liegt dann das effektive Encoder-Signal (A oder B) an.

Die Wahl des Mischers 800 ist dabei vor allem durch Preisüberlegungen dominiert, da das oben beschriebene Verfahren auch unter Verwendung eines eher weniger hochwertigen Mischers befriedigende Ergebnisse liefert. Wie bereits erwähnt, ist der Mischer eine Nichtlinearität und die preisgünstigste Nichtlinearität ist eine Diode. Einzige wesentliche Bedingung ist, dass sie schnell genug ist. Deshalb wird erfindungsgemäß die in Fig. 9 gezeigte Schaltungsanordnung unter Verwendung einer Diode 802 eingesetzt. Hierbei entspricht die in Fig. 9 gezeigte Schaltung im Wesentlichen der in Fig. 8 gezeigten, wobei übersichtlichkeitshalber das Logiktor XOR2 nicht dargestellt ist und eine Diode 802 mit geeigneter Beschaltung den Mischer 800 ersetzt.

Eine weitere Art, einen preisgünstigen Mischer zu realisieren, besteht darin, einen Hochfrequenz-Schalter zu verwenden, der mit dem LO-Signal am Digitaleingang angesteuert ist. Am Ausgang des Schalters entsteht eine differenzielle Spannung, die gefiltert und verstärkt werden kann.

Die RF- und LO-Eingänge der Schaltung aus Fig. 9 sind symmetrisch ausgeführt und gehen auf den gleichen Port, der RF to LO-Leakage ist entsprechend hoch, aber wie bereits erwähnt harmlos. Die 1 kΩ Widerstände dienen der Strombegrenzung, der 4p7 Kondensator verhindert ein Zurückschlagen der IF Terme auf die RF und optimiert die Einschwingzeit der Schaltung.

Die 1 k Widerstände sind hoch und ergeben faktisch eine Stromquelle. Bekanntlich ist der Strom am Eingang und am Ausgang einer Diode gleich, so dass die Nichtlinearität der Diode, was die Ladungsübertragung angeht, wirkungslos ist, wenn für die anstehende Ladung nicht ein Alternativpfad zur Verfügung gestellt wird. Dies ist der Sinn der 3k3 Widerstands.

Die RC-Kombination aus 47k und 47p bildet ein Tiefpassfilter zum Eliminieren des LO und anderer hochfrequenter Komponenten. Der 100p Kondensator dient zusammen mit dem nachfolgenden Verstärker als Hochpass, um den DC-Term g(LO) zu eliminieren. Der nachfolgende Verstärker V2 ist ein zweistufiger limitierender Verstärker, der ausgelegt ist, schnell und robust mit großen Amplitudenschwankungen fertig zu werden. Fig. 10 zeigt schematisch das Verstärkermodul 804.

Durch Verwendung der erfindungsgemäßen Signalverarbeitungselektronik kann eine Einschwingzeit von ca. 4 $\mu$s eingehalten werden. Die RF kann beispielsweise 15 MHz betragen und der LO kann RF/128 = etwa 115 kHz betragen.

Erfindungsgemäß umfasst der kapazitive Winkelkodierer sowohl eine Inkrementalgeberanordnung wie auch eine Absolutgeberanordnung. Das Messprinzip und die Detektions-Elektronik der beiden Anordnungen sind identisch und der Unterschied ist in der Ausgestaltung der Elektroden zu sehen.

Die in Fig. 2 gezeigte Absolutspur des Stators besteht aus fünf Pickups, die jeweils abtasten, ob die Zielscheibe 102 (Absolutspur 106 der Fig. 1) eine 0 oder eine 1 führt. Hierbei wird auch symmetrisch angeregt und die differenzielle Transkapazität gemessen. Damit unabhängig vom Abstand eine Differenz resultiert, besteht die Absolutspur 106 auf dem Stachelrad 100 aus einer 0- und einer 1-Spur. Die 0-Spur ist nahe der Drehachse, die 1-Spur etwas weiter außen angeordnet.

In der gezeigten Ausführungsform führt die Absolutspur 18 Zustände. Aus der Forderung, dass zu jedem Quad-Count ein gültiger Absolutwert ausgegeben wird, ergibt sich, dass die Absolutspur in 72 Positionen einen gültigen Wert abgeben muss. Deshalb müssen die Pickups der geforderten Trennschärfe entsprechend schmal ausfallen. Die sensitive Fläche pro Pickup beträgt etwa 2 % der Fläche, wie sie bei dem Inkremental-Pickup vorliegt.

Um zu vermeiden, dass die Zielscheibe und deren Träger Ladung von der Inkrementalspur aufnimmt, so dass die Absolutspur eine Mischung aus A/B und ihrer eigenen Information liefert, muss die Zielscheibe und deren Träger erfindungsgemäß niederohmig Massepontential führen.

Da dies aber vor allem bei hohen Frequenzen schwierig einzuhalten ist, wird erfindungsgemäß die galvanische Verbindung zwischen dem Motor und der Zielscheibe beispielsweise durch Einsetzen eines Kunststoffzahnrads unterbrochen. Alternativ kann auch der Motorstrom beim 0-Durchgang des Encoders reduziert werden.

Erfindungsgemäß führt die Absolutspur einen 18 Bit-Pseudo-Random-Cyclic (PRC)-Code. Ein solcher Code erlaubt es, nur eine einzige Absolutspur statt deren fünf zu führen. Die Beobachtung von fünf aufeinander folgenden Bits erlaubt eine eindeutige Bestimmung der Position des Stachelrads 100. Der PRC-Code kann beispielsweise mit einem optimierten Brute-Force-Algorithmus ermittelt werden. Die Decodierung erfolgt in einer programmierbaren logischen Steuerschaltung (programmable logic device, PLD).

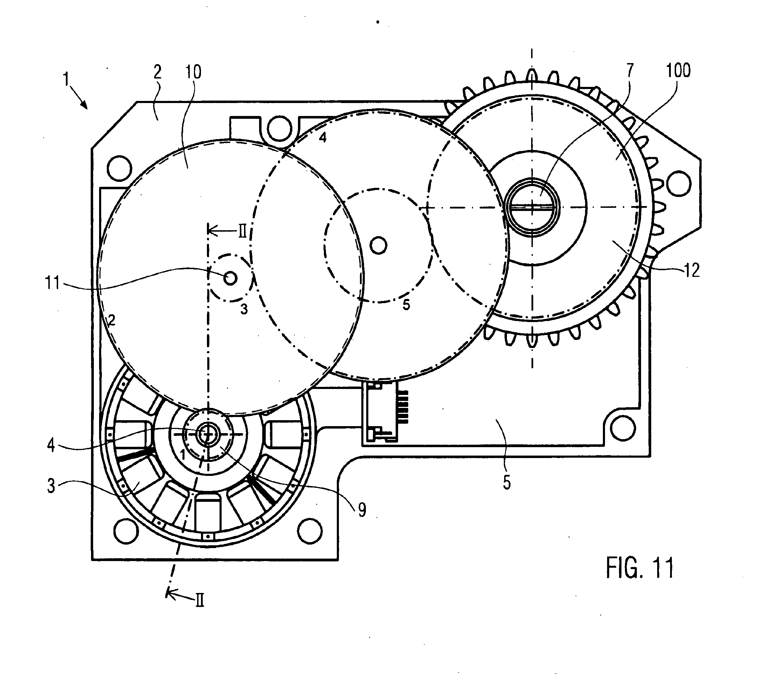

Fig. 11 zeigt in einer Seitenansicht einen Feedereinschub 1 für Bestückungsmaschinen von Leiterplatten, bei dem die Position des Stachelrads 100 durch einen erfindungsgemäßen Winkelkodierer überwacht wird.

Der Feedereinschub 1 weist ein Gehäuse mit einer Seitenwand 2 auf. Auf der Seitenwand 2 ist ein Flachmotor 3 befestigt. Um die Dicke des Feedereinschubs 1 zu reduzieren, ist der Flachmotor 3 so am Gehäuse des Feedereinschubs 1 befestigt, dass die Rotorachse 4 des Flachmotors 3 senkrecht zur Gehäusewand 2 verläuft.

Der Flachmotor 3 kann dazu genutzt werden, ein Transportband anzutreiben, auf dem elektronische Bauteile angeordnet sind, die vom Feeder zur Platzierung auf einer Leiterplatte bereitgestellt werden. Der Flachmotor 3 kann aber auch dazu dienen, eine auf dem Transportband angeordnete Abdeckfolie, mit der die elektronischen Bauteile geschützt werden, von dem Transportband abzuziehen, um Zugriff auf die elektronischen Bauteile zu ermöglichen. Es ist auch möglich, dass der Flachmotor 3 beide Funktionen erfüllt. Im Folgenden wird beschrieben, dass der Flachmotor 3 als Antrieb für das Transportband benutzt wird.

In diesem Fall ist der Flachmotor 3 über eine Getriebeeinheit 5 mit dem Stachelrad 6 verbunden. Das Stachelrad 100 ist ebenfalls auf einer senkrecht zur Seitenwand 2 verlaufenden Achse 7 gelagert. Über das Stachelrad 100 wird das Transportband angetrieben. Dazu weist das Stachelrad 100 an seinem Umfang Zähne bzw. Stachel 8 auf. Das Transportband ist an mindestens einem Rand mit Öffnungen versehen, ähnlich wie ein Film für einen Fotoapparat. Die Stachel 8 des Stachelrads 100 greifen in diese Öffnungen des Transportbands ein und ziehen das Transportband mit sich.

Auf dem Rotor 14 des Flachmotors 3 ist ein Zahnrad 9 angeordnet. Das Zahnrad 9 steht mit einem Zahnrad 10 der Getriebeeinheit 5 in Eingriff. Das Zahnrad 10 ist auf einer Getriebeachse 11 gelagert, die ebenfalls senkrecht zur Seitenwand 2 verläuft. Je nach benötigter Übersetzung weist die Getriebeeinheit 5 weitere auf senkrecht zur Seitenwand verlaufenden Getriebeachsen gelagerte Zahnräder auf. Auch auf der Achse 7 des Stachelrads 6 ist ein Zahnrad 12 angebracht. Die letzte Stufe der Getriebeeinheit 5 steht mit diesem Zahnrad 12 in Eingriff und überträgt die Kraft des Antriebsmotors 3 auf das Stachelrad 100.

Um die auf dem Transportband angeordneten elektronischen Bauteile an die Übergabepositionen für den Bestückungskopf genau zu positionieren, ist direkt am Stachelrad 100 ein die Codescheibe 102 des erfindungsgemäßen Winkelkodierers (oder "Encoders") angebracht. Der Encoder ermöglicht es, die geometrische Abweichung einzelner Zähne des Stachelrads 100 über einen Kalibriervorgang zu kompensieren. Dazu wird das Stachelrad 100 mit einem hochpräzisen Referenzsystem vermessen und die Korrekturwerte werden in einer Datentabelle abgelegt.

Das erfindungsgemäße Encodersystem stellt durch eine oder mehrere zusätzliche Spuren nicht nur die inkrementale, sondern auch die absolute Winkelposition bereit. Bei diesem absoluten Encodersystem ist die Anzahl der zu Verfügung stehenden Absolutpositionen mindestens genauso groß wie die Anzahl der Übergabepositionen am Stachelrad. Damit ist eine direkte Zuordnung zur Korrekturtabelle an jeder Übergabeposition möglich. Es muss damit kein Referenzpunkt angefahren werden, wodurch kein Verlust von Bauteilen entsteht.

**Patentansprüche**

1. Kapazitiver Winkelkodierer zum Erfassen einer Drehstellung eines relativ zu einem stationären Objekt rotatorisch beweglichen Objekts, wobei der Winkelkodierer umfasst:

    einen Stator (108), der mit dem stationären Objekt verbindar ist, wobei der Stator mindestens eine erste Sendeelektrode (112), die so ausgebildet ist, dass sie ein erstes elektrostatisches Feld erzeugt, und mindestens eine erste Empfangselektrode (114) zum Empfangen des ersten elektrostatischen Feldes trägt,
    wobei der Stator weiterhin mindestens eine zweite Sendeelektrode (111), die so ausgebildet ist, dass sie ein zweites elektrostatisches Feld erzeugt, und mindestens eine zweite Empfangselektrode (110) zum Empfangen des elektrostatischen Feldes trägt,
    einen Rotor (100), der mit dem rotierenden Objekt verbin dar ist und mindestens eine Inkrementalkoppelelektrode (104) trägt, die so ausgebildet ist, dass das erste elektrostatische Feld durch eine Kapazitätsänderung in Antwort auf eine Änderung der Drehstellung des Rotors moduliert wird, wobei der Rotor weiterhin mindestens eine Absolutwertkoppelelektrode (106) trägt, die so ausgebildet ist, dass das zweite elektrostatische Feld durch eine Kapazitätsänderung in Antwort auf eine absolute Drehstellung des Rotors moduliert wird;
    einer Signalverarbeitungsschaltung, die so angeschlossen ist, dass sie das erste und zweite modulierte elektrostatische Feld erfasst und in Antwort auf das erfasste Feld einen Messwert für die Position des sich bewegenden Objekts bestimmt,
    **dadurch gekennzeichnet,**
    **dass** die ersten Sendeelektroden und die ersten Empfangselektroden als eine Vielzahl vom Interdigitalelektroden umlaufend äquidistant an dem Stator (108) angeordnet sind.

2. Winkelkodierer nach Anspruch 1, wobei die mindestens eine erste und zweite Sendeelektrode und die mindestens eine erste und zweite Empfangselektrode koplanar zu-einander angeordnet sind.

3. Winkelkodierer nach Anspruch 1 oder 2, wobei die mindestens eine erste Sendeelektrode (112) durch vier Gruppen von Sendeelektroden gebildet ist, die so verschaltet sind, dass jede Gruppe mit einem zu den übrigen Gruppen im Wesentlichen orthogonalen Sendesignal gespeist wird.

4. Winkelkodierer nach mindestens einem der vorangegangenen Ansprüche, wobei die Inkrementalkoppelelektrode (104) eine sinusförmige Struktur aufweist, die umlaufend an dem Rotor (100) ausgebildet ist.

5. Winkelkodierer nach mindestens einem der vorangegangenen Ansprüche, wobei die Inkrementalkoppelelektrode (104) eine rechteckförmige Struktur aufweist, die umlaufend an dem Rotor (100) ausgebildet ist.

6. Winkelkodierer nach mindestens einem der vorangegangenen Ansprüche, wobei eine Absolutwertkoppelelektrode (106) mindestens eine stufenförmige Struktur aufweist, die umlaufend an dem Rotor (100) ausgebildet ist.

7. Winkelkodierer nach mindestens einem der vorangegangenen Ansprüche, wobei die zweiten Sendeelektroden (111) durch eine Vielzahl von unsymmetrisch in einem Bereich des Rotors angebrachten Elektrodenstrukturen gebildet sind und die zweiten Empfangselektroden durch interdigital zwischen den zweiten Sendeelektroden angeordneten Elektrodenstrukturen gebildet sind.

8. Winkelkodierer nach mindestens einem der vorangegangenen Ansprüche, wobei die Signalverarbeitungsschaltung eine Inkrementalkodierereinheit, die mit der mindestens einen ersten Empfangselektrode verbunden ist, und eine Absolutkodierereinheit, die mit der mindestens einen zweiten Empfangselektrode verbunden ist, umfasst.

9. Winkelkodierer nach mindestens einem der vorangegangenen Ansprüche, wobei die Signalverarbeitungsschaltung eine Phaseshift-Keying-Heterodyn-Architektur aufweist.

10. Winkelkodierer nach mindestens einem der vorangegangenen Ansprüche, wobei das Signal der zweiten Empfangselektroden einen Absolutwert liefert, der mittels eines Pseudo-Random-Cyclic Codes codiert ist.

**11.** Winkelkodierer nach einem der Ansprüche 8 bis 10, wobei redundante zweite Empfangselektroden zur Fehlerkorrektur vorgesehen sind.

**12.** Winkelkodierer nach mindestens einem der vorangegangenen Ansprüche, wobei die Absolutwertkoppelelektrode (106) zwei zueinander komplementäre an dem Rotor umlaufend angeordnete Absolutspuren umfasst.

**13.** Winkelkodierer nach mindestens einem der vorangegangenen Ansprüche, wobei die Elektroden des Stators als Leiterbahnen auf einem gedruckten Schaltungssubstrat ausgebildet sind.

**14.** Feedereinschub für Bestückungsmaschinen von Leiterplatten mit einem Gehäuse, einem Antriebsmotor (3), einem Getriebe (5) und einem mit einem Transportband in Eingriff stehenden Stachelrad (100), wobei die Drehstellung des Stachelrads zur Positionierung des Transportbandes mittels eines Winkelkodierers nach mindestens einem der Ansprüche 1 bis 13 erfasst wird.

**15.** Feedereinschub nach Anspruch 14, wobei die Impulszahl des Winkelkodierers mit der Anzahl von Übergabepositionen des Stachelrads identisch ist.

**16.** Feedereinschub nach Anspruch 14 oder 15, wobei das Stachelrad vom dem Antriebsmotor galvanisch getrennt ist.

**17.** Feedereinschub nach einem der Ansprüche 14 bis 16, wobei der Antriebsmotor so ansteuerbar ist, dass bei einem Nulldurchgang des Winkelkodierers der Motorstrom reduziert wird.

**Claims**

**1.** Capacitive angular encoder for detecting a rotational position of a rotationally movable object relative to a stationary object, the angular encoder comprising:

a stator (108) which can be connected to the stationary object, wherein the stator carries at least one first transmitting electrode (112) adopted to generate a first electrostatic field and at least one first receiving electrode (114) for receiving the first electrostatic field,
wherein the stator further carries at least one second transmitting electrode (111) adopted to generate a second electrostatic field and at least one second receiving electrode (110) for receiving the electrostatic field,
a rotor (100) which can be connected to the rotating object and carries at least one incremental coupling electrode (104) adopted to modulate the first electrostatic field by a change in capacitance in response to a change of the rotational position of the rotor, wherein the rotor further carries at least one absolute-value coupling electrode (106) adopted to modulate the second electrostatic field by a change in capacitance in response to an absolute rotational position of the rotor,
a signal processing circuit which is connected to detect the first and second modulated electrostatic field and determine a measured value for the position of the moving object in response to the detected field,
**characterized in that**
the first transmitting electrodes and the first receiving electrodes are arranged on the stator (108) as a plurality of circumferentially equidistant interdigital electrodes.

**2.** Angular encoder according to claim 1, wherein the at least one first and second transmitting electrode and the at least one first and second receiving electrode are arranged coplanar with respect to each other.

**3.** Angular encoder according to claim 1 or 2, wherein the at least one first transmitting electrode (112) is formed by four groups of transmitting electrodes, which are interconnected in such a way that each group is supplied with a transmit signal which is substantially orthogonal with respect to the other groups.

**4.** Angular encoder according to at least one of the preceding claims, wherein the incremental coupling electrode (104) has a sinusoidal structure which is formed circumferentially on the rotor (100).

**5.** Angular encoder according to at least one of the preceding claims, wherein the incremental coupling electrode (104) has a rectangular structure which is formed circumferentially on the rotor (100).

**6.** Angular encoder according to at least one of the preceding claims, wherein an absolute-value coupling electrode (106) has at least one step-shaped structure which is formed circumferentially on the rotor (100).

7. Angular encoder according to at least one of the preceding claims, wherein the second transmitting electrodes (111) are formed by a plurality of electrode structures arranged asymmetrically in a portion of the rotor and the second receiving electrodes are formed by electrode structures arranged interdigitally between the second transmitting electrodes.

8. Angular encoder according to at least one of the preceding claims, wherein the signal processing circuit comprises an incremental coding unit connected to the at least one first receiving electrode and an absolute coding unit connected to the at least one second receiving electrode.

9. Angular encoder according to at least one of the preceding claims, wherein the signal processing circuit comprises a phase shift keying heterodyne architecture.

10. Angular encoder according to at least one of the preceding claims, wherein the signal of the second receiving electrodes supplies an absolute value which is coded by a pseudo-random-cyclic code.

11. Angular encoder according to one of claims 8 to 10, wherein redundant second receiving electrodes are provided for error correction.

12. Angular encoder according to at least one of the preceding claims, wherein the absolute-value coupling electrode (106) comprises two absolute tracks which are complementary with respect to each other and are arranged circumferentially on the rotor.

13. Angular encoder according to at least one of the preceding claims, wherein the electrodes of the stator are realized as conductor tracks on a printed circuit substrate.

14. Insertable feeder for printed circuit board insertion machines, comprising a housing, a driving motor (3), a transmission (5) and a pin feed platen (100) engaged with a conveyor belt, wherein the rotational position of the pin feed platen for positioning the conveyor belt is detected by means of an angular encoder according to at least one of claims 1 to 13.

15. Insertable feeder according to claim 14, wherein the pulse number of the angular encoder is identical with the number of transfer positions of the pin feed platen.

16. Insertable feeder according to claim 14 or 15, wherein the pin feed platen is galvanically isolated from the driving motor.

17. Insertable feeder according to one of claims 14 to 16, wherein the driving motor can be driven to reduce the motor current during a zero crossing of the angular encoder.

**Revendications**

1. Dispositif de codage angulaire capacitif destiné à une détection d'une position de rotation d'un objet mobile en rotation par rapport à un objet stationnaire, le dispositif de codage angulaire comprenant:

un stator (108), qui peut être relié à l'objet stationnaire, le stator portant au moins une première électrode d'émission (112), qui est formée de manière à produire un premier champ électrostatique, et au moins une première électrode de réception (114) destinée à une réception du premier champ électrostatique,
où le stator porte en outre au moins une deuxième électrode d'émission (111), qui est formée de manière à produire un second champ électrostatique, et au moins une seconde électrode de réception (110) destinée à la réception du champ électrostatique,
un rotor (100), qui peut être relié avec l'objet en rotation et porte au moins une électrode de couplage incrémental (104), qui est formée de manière à ce que le premier champ électrostatique soit modulé par une variation de capacité en réponse à une modification de la position de rotation du rotor, le rotor portant en outre au moins une électrode de couplage en valeur absolue (106), qui est formée de manière à ce que le second champ électrostatique soit modulé grâce à une variation de capacité en réponse à une position absolue de rotation du rotor ;

un circuit de traitement de signal, qui est connecté de manière à ce qu'il détecte le premier et le second champ électrostatique modulé et détermine une valeur de mesure pour la position de l'objet en mouvement en réponse au champ détecté,

**caractérisé en ce que**

les premières électrodes d'émission et les premières électrodes de réception sont agencées de manière circonférentiellement équidistante au niveau du stator (108) sous la forme d'une pluralité d'électrodes interdigitées.

2. Dispositif de codage angulaire selon la revendication 1, où les au moins une première et seconde électrodes d'émission et les au moins une première et seconde électrodes de réception sont agencées de manière coplanaire les unes par rapport aux autres.

3. Dispositif de codage angulaire selon la revendication 1 ou 2, où la au moins une première électrode d'émission (112) est formée par quatre groupes d'électrodes d'émission, qui sont connectés de manière à ce que chaque groupe soit alimenté avec un signal d'émission essentiellement orthogonal par rapport aux groupes restants.

4. Dispositif de codage angulaire selon au moins l'une quelconque des revendications précédentes, où l'électrode de couplage incrémental (104) présente une structure sinusoïdale, qui est formée de manière circonférentielle au niveau du rotor (100).

5. Dispositif de codage angulaire selon au moins l'une quelconque des revendications précédentes, où l'électrode de couplage incrémental (104) présente une structure rectangulaire, qui est formée de manière circonférentielle au niveau du rotor (100).

6. Dispositif de codage angulaire selon au moins l'une quelconque des revendications précédentes, où une électrode de couplage en valeur absolue (106) présente au moins une structure en gradins, qui est formée de manière circonférentielle au niveau du rotor (100).

7. Dispositif de codage angulaire selon au moins l'une quelconque des revendications précédentes, où les secondes électrodes d'émission (111) sont formées par une pluralité de structures formant électrodes montées de manière asymétrique dans un secteur du rotor et les secondes électrodes de réception sont formées par des structures formant électrodes agencées de manière interdigitées entre les secondes électrodes d'émission.

8. Dispositif de codage angulaire selon au moins l'une quelconque des revendications précédentes, où le circuit de traitement de signal comprend un module de codage incrémental, qui est relié avec la au moins une première électrode de réception, et un module de codage absolu qui est relié avec la au moins une seconde électrode de réception.

9. Dispositif de codage angulaire selon au moins l'une quelconque des revendications précédentes, où le circuit de traitement de signal présente une architecture hétérodyne avec modulation par déplacement de phase.

10. Dispositif de codage angulaire selon au moins l'une quelconque des revendications précédentes, où le signal des secondes électrodes de réception délivre une valeur absolue, qui est codée au moyen d'un code cyclique pseudo-aléatoire.

11. Dispositif de codage angulaire selon l'une quelconque des revendications 8 à 10, où des secondes électrodes de réception redondantes sont prévues en vue d'une correction d'erreur.

12. Dispositif de codage angulaire selon au moins l'une quelconque des revendications précédentes, où l'électrode de couplage en valeur absolue (106) comprend deux pistes absolues complémentaires l'une par rapport à l'autre agencées de manière circonférentielle au niveau du rotor.

13. Dispositif de codage angulaire selon au moins l'une quelconque des revendications précédentes, où les électrodes du stator sont formées en tant que circuits conducteurs sur un substrat imprimé formant circuit.

14. Chargeur enfichable pour machines de montage de circuits imprimés avec un boîtier, un moteur d'entraînement (3), un mécanisme de transmission (5) et une roue dentée (100) s'engrenant avec une courroie transporteuse, la position de rotation de la roue dentée étant détectée au moyen d'un dispositif de codage angulaire selon au moins l'une quelconque des revendications 1 à 13 en vue d'un positionnement de la courroie transporteuse.

**15.** Chargeur enfichable selon la revendication 14, où le nombre d'impulsions du dispositif de codage angulaire est identique au nombre de positions de transfert de la roue dentée.

**16.** Chargeur enfichable selon la revendication 14 ou 15, où la roue dentée est séparée du moteur d'entraînement de manière galvanique.

**17.** Chargeur enfichable selon l'une quelconque des revendications 14 à 16, où le moteur d'entraînement peut être commandé de manière à ce que le courant de moteur soit réduit lors d'un passage par zéro du dispositif de codage angulaire.

FIG. 1

FIG. 2

108

FIG. 3

FIG. 4

FIG. 5

FIG. 6

FIG. 7

FIG. 8

FIG. 9

FIG. 10

FIG. 11

EP 2 095 078 B1

18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006024733
- WO 0063653 A2
- US 2005092108 A1
- US 6170162 B1

**In der Beschreibung aufgeführte Nicht-Patentliteratur**

- AN INTEGRABLE CAPACITIVE ANGULAR DISPLACEMENT SENSOR WITH IMPROVED LINEARITY. **WOLFENBUTTEL R F et al.** SENSORS AND ACTUATORS. ELSEVIER SEQUOIA S.A, 01. Mai 1991, vol. A27, 835-843